# EUROPEAN PATENT APPLICATION

(11) **EP 1 089 291 A2**
(43) Date of publication of application: **04.04.2001**
(21) Application number: 00308170.0
(22) Date of filing: 19.09.2000
(51) Int. Cl.: G11C 19/28, G09G 3/32

(54) **Shift register and image display apparatus using the same**

(30) Priority: 29.09.1999 JP 27630099
(71) Applicant: TDK Corporation, Chuo-ku, Tokyo (JP)
(72) Inventor: Takayama, Ichiro, TDK Corporation, Tokyo (JP)
(74) Representative: Sarup, David Alexander

(57) **Abstract**

In a shift register comprising switching devices having an active layer formed of polycrystalline silicon, an electric charge that is charged to the shift register through a power supply line is transferred to a next stage (M2, M4) through only one switching device (M1, M3). The shift register eliminates the influence of the operating speed of polycrystalline silicon and enables high-speed, high-definition display.

## Description

### FIELD OF THE INVENTION

This invention relates to a shift register using polycrystalline silicon, and more particularly, to a high-speed shift register suitable for use in an image display apparatus capable of high-speed display such as an organic EL display apparatus.

### BACKGROUND ART

Display apparatus using organic electroluminescent (EL) devices have been developed. When an array of a plurality of organic EL devices is driven by an active matrix circuit, each EL device serving as a pixel is coupled with a set of field effect transistors (FETs), typically thin-film transistors (TFTs), for controlling the current flow to the pixel. More particularly, each EL device is coupled with a pair of a biasing TFT for flowing drive current across the organic EL device and a switching TFT for selectively turning on the biasing TFT.

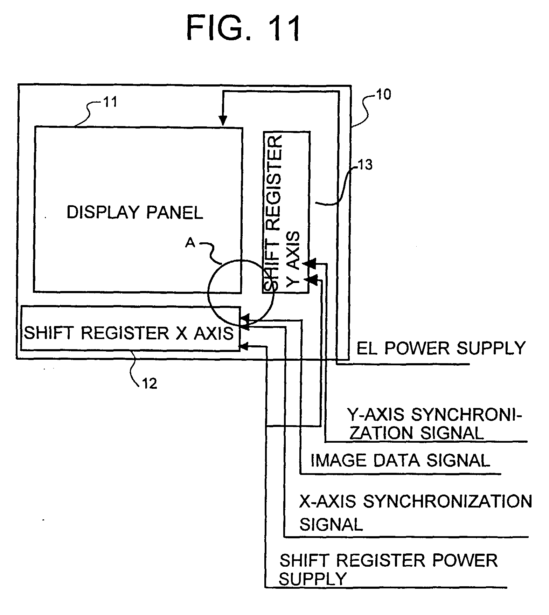

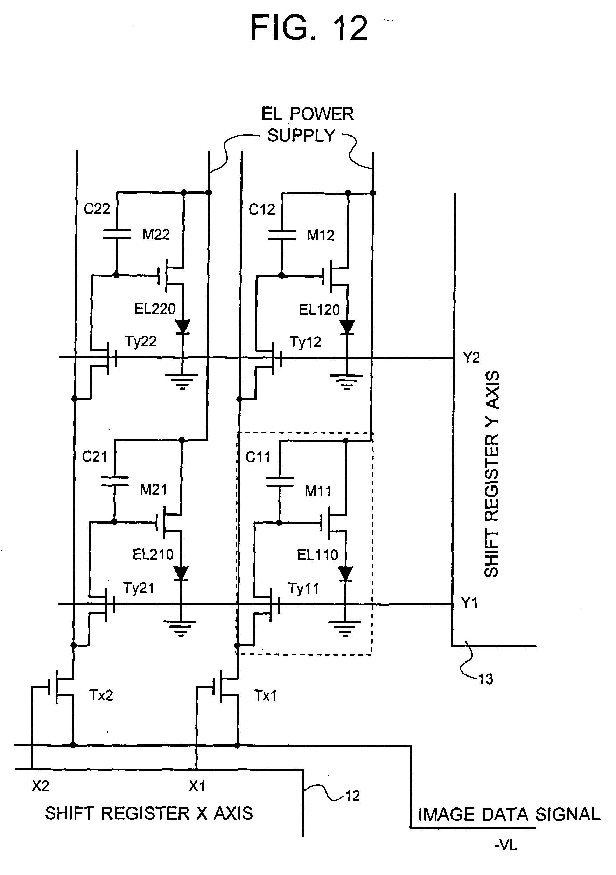

FIGS. 11 and 12 illustrate one exemplary circuit of a prior art organic EL display apparatus of the active matrix type. This organic EL display apparatus 10 includes X-direction signal lines X1, X2, ..., Y-direction signal lines Y1, Y2, ..., power supply Vdd lines Vdd1, Vdd2, ..., switching TFTs Ty11, Ty12, Ty21, Ty22, ..., current controlling TFTs M11, M12, M21, M22. ..., organic EL devices EL110, EL120, EL210, EL220, ..., capacitors C11, C12, C21, C22, ..., X-direction peripheral driver circuit 12, and Y-direction peripheral driver circuit 13 and display panel 11.

A particular pixel is appointed by X-direction signal lines X1, X2 and Y-direction signal lines Y1, Y2. At that pixel, the corresponding one of the switching TFTs Ty11, Ty12, Ty21, Ty22 is turned on whereby image data is stored in the corresponding one of the signal-holding capacitors C11, C12, C21, C22. Then the current controlling TFT M11, M12, M21 or M22 is turned on, allowing the biasing current to flow to the organic EL device EL110, EL120, EL210 or EL220 from the power supply line Vdd1 or Vdd2 in accordance with the image data whereby the organic EL device emits light.

For instance, when a signal corresponding to the image data is delivered to X-direction signal line X1 and a Y-direction scanning signal is delivered to Y-direction signal line Y1, switching TFT Ty11 corresponding to the pixel appointed thereby is turned on. The signal corresponding to the image data causes current controlling TFT M11 to turn on, allowing the light-emitting current corresponding to the image data to flow to the organic EL device EL110, thereby accomplishing controlled light emission. In the organic EL display apparatus of the active matrix type having for each pixel, a thin film type EL device, a current controlling TFT for controlling the light emission of the EL device, a signal holding capacitor connected to the gate electrode of the current controlling TFT, and a switching TFT for writing data in the capacitor as described above, the intensity of light emission of EL device is determined by the current flow across the TFT that is a light-emitting current controlling nonlinear element which is controlled by the voltage accumulated in the signal holding capacitor. See A66-in 201pi Electroluminescent Display, T.P. Brody, F.C. Luo, et al., IEEE Trans Electron Devices, Vol. ED-22, No. 9, Sep. 1975, pp. 739-749.

The capacitance of the signal holding capacitor used should be below the capacitance to be fully charged by the pixel switching TFT within a minute selection time and above the capacitance at which the image on the display panel is not adversely affected by a lowering of the holding voltage of the capacitor caused by the electric charge that is lost, until the next writing point of time, by the current leaking when the pixel switching TFT is not selected.

From the visibility standpoint, the display apparatus of the active matrix type requires a view angle of at least 4 inches unless an optical system for expanded projection is used.

A substantial cost is necessary in constructing a display area of this size on a single crystal silicon substrate, because with the current technology of manufacturing a single crystal silicon substrate, the number of single crystal substrates cut from a single crystal plate is very small.

Then, for the display apparatus of the active matrix type, it is desirable to employ thin film transistors (TFTs) using a semiconductor layer of non-single-crystal silicon formed on a planar substrate such as a glass substrate.

Since it is relatively easy to form a semiconductor layer of a large area on a planar substrate, an amorphous silicon (a-Si) film is often used.

TFT formed using an a-Si film has the problem that when electric current continues to flow constantly in one direction, the threshold drifts to change the current value, introducing a variation in image quality. In addition, the a-Si film has a low mobility, imposing a limit on the current flow which can be driven on high-speed response. Since the formation of a P channel is difficult, it is difficult to construct even a small-size c-MOS circuit.

It is then desirable to use polycrystalline silicon (poly-Si) as the semiconductor layer in the organic EL image display apparatus of the active matrix type, because polycrystalline silicon is relatively easy to form a layer of a large area, has a high reliability and a high mobility, and allows for formation of a c-MOS circuit.

However, TFT formed using a poly-Si layer has the problem that the mobility is lower than that of single crystal because of crystal grain boundaries in the channel and crystal distortion. It is then difficult to apply this TFT to a driver circuit for a high definition display which reguires higher speed driving.

One prior art shift register using polycrystalline silicon TFTs is disclosed in Misawa et al., USP 5,250,931 (JP-A 1-289917). The circuit diagrams of these shift registers are shown in FIGS. 13 and 14.

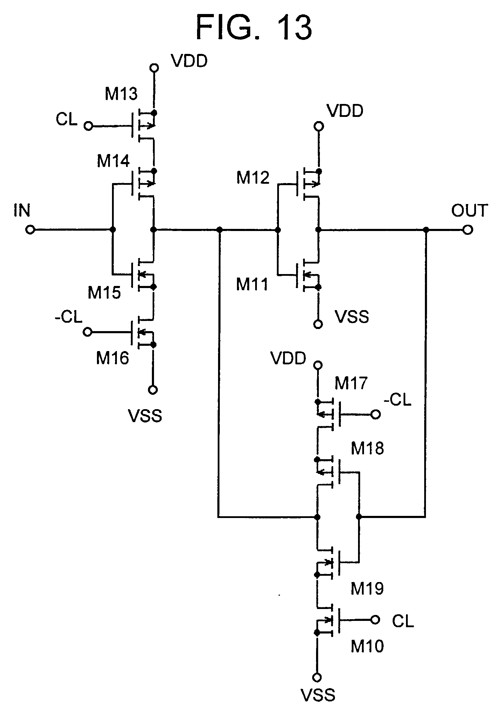

The shift register illustrated in FIG. 13 includes, as a basic constituent unit, a first clocked inverter consisting of p-channel transistors M13, M14 and n-channel transistors M15, M16, an inverter consisting of a p-channel transistor M12 and an n-channel transistor M11, and a second clocked inverter consisting of p-channel transistors M17, M18 and n-channel transistors M19, M20. A clock CL of positive logic is delivered to the p-channel transistor M13 of the first clocked inverter, and a clock -CL of negative logic delivered to the n-channel transistor M16. Also, a clock -CL of negative logic is delivered to the p-channel transistor M17 of the second clocked inverter, and a clock CL of positive logic delivered to the n-channel transistor M19. The output of the inverter is connected to the input of the second clocked inverter, and the input of the inverter connected to the output of the second clocked inverter.

With this construction, an input pulse given to the input terminal IN is admitted in synchronization with the clock signal CL, and a signal delayed by one clock is delivered from the output terminal OUT.

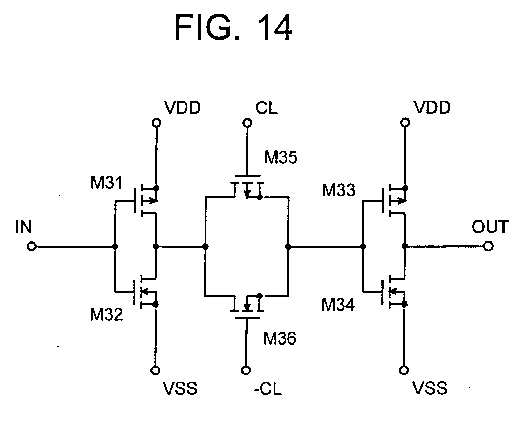

The shift register illustrated in FIG. 14 includes, as a basic constituent unit, a first inverter consisting of a p-channel transistor M31 and an n-channel transistor M32, a second inverter consisting of a p-channel transistor M33 and an n-channel transistor M34, and a switching circuit interposed between these inverters and consisting of a p-channel transistor M35 and an n-channel transistor M36.

With this construction too, an input pulse given to the input terminal IN is admitted in synchronization with the clock signal CL, and a signal delayed by one clock is delivered from the output terminal OUT.

However, these shift registers need at least two switching devices until an input signal is transferred to a next stage in synchronization with a clock signal. Differently stated, the electric charge charged from a power supply line and discharged therefrom is transferred to a next stage through at least two switching devices. As a consequence, when switching devices using an active layer of poly-Si featuring a slower operating speed than single crystal are employed in these shift registers, the registers encounter difficulty in catching up with high-speed operation.

### SUMMARY OF THE INVENTION

An object of the invention is to provide a shift register which eliminates the influence of the operating speed of polycrystalline silicon and enables high-speed operation. Another object of the invention is to provide an image display apparatus which is manufactured at a low cost using the shift register.

In one aspect, the invention provides a shift register comprising switching devices having an active layer formed of polycrystalline silicon, wherein an electric charge that is charged to the shift register through a power supply line and discharged therefrom is transferred to a next stage (M2, M4) through only one switching device (M1, M3).

In one preferred embodiment, the shift register has a pair of switching devices (M1, M3) capable of complimentary operation as an operating unit, wherein a signal is transferred to the next stage (M2, M4) by the pair of switching devices (M1, M3). Also preferably, the operating unit is adapted to transfer an input signal to the next stage in synchronization with a clock signal.

In another aspect, the invention provides a shift register comprising a first pair of switching devices (M1, M3) having an active layer formed of polycrystalline silicon as a first operating unit, the pair of switching devices being capable of complimentary operation and functioning as an inverter, the shift register further comprising a second pair of complimentary, series connected switching devices (M2, M4), wherein a clock signal is fed to a controlled terminal of one (M1) of the first pair of switching devices, an output of the first operating unit is fed to a control terminal of one (M4) of the second pair of switching devices while the clock signal is fed to a control terminal of the other (M4) of the second pair of switching devices, and an output signal is delivered from an intermediate between the second pair of switching devices (M2, M4).

Preferably, the shift register has an off current of up to 1x10⁻⁷ A, and an electric field of up to 0.2 MV/cm is applied between controlled electrodes of each switching device.

Also contemplated herein is an image display apparatus comprising the shift register defined above. Typically the image display apparatus further includes an organic EL device as a pixel.

### BRIEF DESCRIPTION OF THE DRAWINGS

FIG. 1 is a circuit diagram showing one exemplary arrangement of the shift register according to the invention.
FIG. 2 is a timing chart showing the operation of the circuit of FIG. 1.
FIG. 3 is a graph showing the maximum operating frequency versus power supply voltage of a shift register in Example.
FIGS. 4 through 10 are cross-sectional views showing successive steps of a process for fabricating a TFT of which the shift register of the invention is constructed.
FIG. 11 is a block diagram of a prior art image display apparatus.
FIG. 12 is an enlarged view of circled portion A in FIG. 11.
FIG. 13 is a circuit diagram showing the arrangement of one exemplary prior art shift register.
FIG. 14 is a circuit diagram showing the arrangement of another exemplary prior art shift register.

### DESCRIPTION OF THE PREFERRED EMBODIMENT

The image display apparatus of the invention includes a shift register comprising switching devices having an active layer formed of poly-Si. The electric charge that is charged to the shift register through a power supply line and discharged therefrom is transferred to a next stage M2, M4 through only one switching device M1, M3. Specifically, the shift register has a pair of switching devices M1, M3 capable of complimentary operation as an operating unit, and the pair of switching devices M1, M3 transfer a signal to the next stage M2, M4. This operating unit transfers an input signal to the next stage in synchronization with a clock signal.

Since the electric charge that is charged to the shift register through a power supply line and discharged therefrom, that is, input is transferred to the next stage M2, M4 through only one switching device M1, M3, the delay associated with the operation of one device is eliminated, achieving a significant improvement in the operating speed of the overall shift register.

More particularly, the shift register has a first pair of switching devices M1, M3 whose active layer is formed of poly-Si as a first operating unit, the pair of switching devices being capable of complimentary operation and functioning as an inverter, and a second pair of complimentary, series connected switching devices M2, M4. A clock signal is fed to a controlled terminal of one switching device M1 of the first pair, an output of the first operating unit is fed to a control terminal of one switching device M4 of the second pair while the clock signal is fed to a control terminal of the other switching device M4 of the second pair, and an output signal is delivered from an intermediate between the second pair of switching devices M2, M4.

In this way, in the first stage of basic constituent unit of the inverter, a clock signal rather than a power supply is fed to one of the controlled terminals of push-pull connected (or complementary) switching devices. In the next stage where a pair of cascade connected, complementary switching devices are provided, one switching device receives at its control terminal the output signal from the first stage, the other switching device receives at its control terminal the clock signal, and an output is delivered from the intermediate between theses switching devices. Then the input signal is transferred in synchronization with the clock by way of only one switching device, whereby the output signal delayed by one clock is delivered.

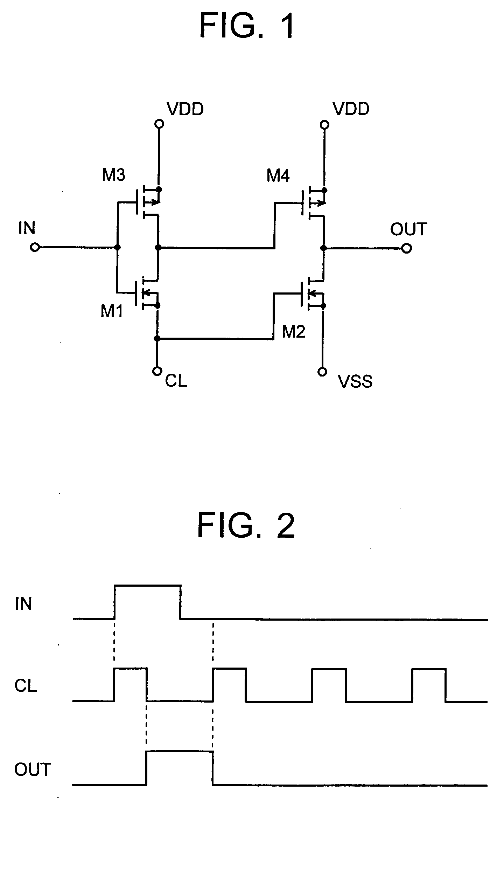

Referring to the drawings, the shift register of the invention is described in further detail. FIG. 1 is a circuit diagram showing one exemplary arrangement of the shift register according to the invention. FIG. 2 is a timing chart showing the operation of the circuit.

In FIG. 1, a first stage consists of a pair of first and third switching devices M1 and M3 having control terminals or gates both connected to an input terminal IN. The first switching device M1 has a pair of controlled terminals one (source) of which is connected to a clock input terminal CL. The other controlled terminal (drain) of the first switching device M1 is connected to one controlled terminal (drain) of the third switching device M3. Connected to the other controlled terminal (source) of the third switching device M3 is a power supply VDD.

As the first and third switching devices M1 and M3 of the first stage, a pair of switching devices capable of complimentary operation or push-pull operation are preferably selected and used. In the illustrated embodiment, the first switching device M1 is of N type and the third switching device M3 is of P type.

A next stage consists of a pair of second and fourth switching devices M2 and M4. The second switching device M2 has a control terminal or gate connected to the clock input terminal CL. One controlled terminal (drain) of the second switching device M2 is connected to one controlled terminal (drain) of the fourth switching device M4 and to an output terminal OUT. The other controlled terminal (source) of the second switching device M2 is connected to a negative power supply VSS. The control terminal of the fourth switching device M4 is connected to both the controlled terminal (drain) of the first switching device M1 and the controlled terminal (drain) of the third switching device M3 of the first stage. Connected to the other controlled terminal (source) of the fourth switching device M4 is a power supply VDD.

As the second and fourth switching devices M2 and M4 of the next stage, a pair of switching devices capable of complimentary operation or push-pull operation are preferably selected and used. In the illustrated embodiment, the second switching device M2 is of N type and the fourth switching device M4 is of P type.

In the shift register of the illustrated construction, upon receipt of an input pulse signal as shown in FIG. 2, it is provided to the control terminals of the first and third switching devices M1 and M3 in the first stage. The first and third switching devices M1 and M3 operate in accordance with the input signal while a clock signal is fed to the controlled terminal of the first switching device M1. Then the input signal is admitted in synchronization with the clock signal and transferred to the next stage as an output signal. The fourth switching device M4 of the next stage operates in accordance with the output signal from the first stage while the second switching device M2 in cascade connection therewith operates in accordance with the clock signal CL. Consequently, the output of these switching devices is also delivered in accordance with the clock signal. Since the first stage operates such that the signal is processed at the fall of the clock signal and the next stage operates such that the signal is processed at the rise of the clock signal, the output signal is delayed by one clock as shown in FIG. 2.

The switching devices used herein may be conventional bipolar transistors or field effect transistors (FET) and especially, thin film transistors (TFT) of c-MOS type.

The shift register of the invention favors an off current of up to 1x10⁻⁷ A, and especially up to 1x10⁻⁸ A. The lower limit of the off current is not critical although it is usually about 1x10⁻¹⁰ A. An off current above the limit may adversely affect stability.

In the shift register of the invention, the electric field applied between the controlled terminals (drain and source) of the switching device is preferably up to 0.2 MV/cm, and especially up to 0.1 MV/cm. The lower limit of the electric field is not critical although it is usually about 0.05 MV/cm. An electric field intensity above the limit may adversely affect stability.

The shift register of the invention provides for a maximum operating frequency of about twice greater than conventional shift registers using poly-Si.

The shift register of the invention is not critical as long as the active layers of the switching devices are constructed of poly-Si and high-speed operation is required in its application. It is useful in a variety of applications, and especially liquid crystal and inorganic and organic EL image display apparatus.

Most preferably the shift register of the invention is combined with an organic EL device, which is a self light-emitting device capable of fast operation, to construct an image display apparatus.

Next, the construction of the organic EL device which is advantageously used herein is described. The organic EL device includes first and second electrodes, and an organic layer disposed therebetween and containing at least an organic material participating in a light emitting function. The first and second electrodes supply electrons and holes to the organic layer where they are recombined to emit light.

Either of the first and second electrodes may be a hole or electron injecting electrode. Most often, the first electrode disposed closer to the substrate is a hole injecting electrode and the second electrode remote from the substrate is an electron injecting electrode.

The electron injecting electrode is preferably made of a material having a low work function, for example, a metal element such as K, Li, Na, Mg, La, Ce, Ca, Sr, Ba, Al, Ag, In, Sn, Zn or Zr, and binary or ternary alloys made of two or three such metal elements for stability improvement. Exemplary alloys are Ag-Mg (Ag: 0.1 to 50 at%), Al-Li (Li: 0.01 to 14 at%), In-Mg (Mg: 50 to 80 at%), and Al-Ca (Ca: 0.01 to 20 at%). It is understood that the electron injecting electrode can be formed by evaporation or sputtering.

The electron injecting electrode thin film may have a sufficient thickness for electron injection, for example, a thickness of at least 0.5 nm, preferably at least 1 nm, and more preferably at least 3 nm. Although the upper limit is not critical, the electrode thickness is typically about 3 to about 500 nm. On the electron injecting electrode, an auxiliary or protective electrode may be provided, if desired.

During evaporation, an appropriate pressure is 1x10⁻⁸ to 1x10⁻⁵ Torr and the heating temperature of the evaporation source is about 100°C to about 1,400°C for metal materials and about 100°C to about 500°C for organic materials.

A transparent or translucent electrode is preferred as the hole injecting electrode so that emitted light may exit from the substrate side. Useful materials for transparent electrodes include tin-doped indium oxide (ITO), zinc-doped indium oxide (IZO), zinc oxide (ZnO), tin oxide (SnO₂), and indium oxide (In₂O₃), with ITO and IZO being preferred. The ITO usually contains In₂O₃ and SnO₂ in stoichiometry although the oxygen content may deviate somewhat therefrom. Opaque, well-known metal materials may be used when the hole injecting electrode need not be transparent.

The hole injecting electrode should have a sufficient thickness for hole injection and is preferably about 50 to about 500 nm thick, especially about 50 to 300 nm thick. Although no upper limit need be imposed on the thickness of the hole injecting electrode, too thick electrodes can peel off. A too thin electrode is undesirable in film strength, hole transporting capability, and resistivity.

The hole injecting electrode can be formed by evaporation or other techniques although sputtering, especially pulse DC sputtering is preferable.

The organic layers in the organic EL structure may be constructed as described below.

The light emitting layer has functions of injecting holes and electrons, transporting them, and recombining holes and electrons to create excitons. It is preferred to use relatively electronically neutral compounds in the light emitting layer.

The hole injecting and transporting layer has functions of facilitating injection of holes from the hole injecting electrode, transporting them stably, and blocking electrons. The electron injecting and transporting layer has functions of facilitating injection of electrons from the electron injecting electrode, transporting them stably, and blocking holes. These layers are effective for increasing the number of holes and electrons injected into the light emitting layer and confining holes and electrons therein for optimizing the recombination region to improve light emission efficiency.

The thicknesses of the light emitting layer, hole injecting and transporting layer, and electron injecting and transporting layer are not critical and vary with a particular formation technique. Usually a single layer is about 5 to 500 nm thick, especially about 10 to 300 nm thick.

The thicknesses of the hole injecting and transporting layer and electron injecting and transporting layer are equal to or range from 1/10 to 10 times the thickness of the light emitting layer although they depend on the design of a recombination/light emitting region. When the electron or hole injecting and transporting layer is divided into an injecting layer and a transporting layer, preferably the injecting layer is at least 1 nm thick and the transporting layer is at least 1 nm thick. The upper limit of thickness is generally about 500 nm for the injecting layer and about 500 nm for the transporting layer. The same applies when two injecting and transporting layers are provided.

The light emitting layer contains a fluorescent material that is a compound having a light emitting capability. The fluorescent material may be at least one member selected from compounds as disclosed, for example, in JP-A 63-264692, such as quinacridone, rubrene, and styryl dyes. Also, quinoline derivatives such as metal complex dyes having 8-quinolinol or a derivative thereof as the ligand such as tris(8-quinolinolato)aluminum are included as well as tetraphenylbutadiene, anthracene, perylene, coronene, and 12-phthaloperinone derivatives. Further useful are the phenylanthracene derivatives described in JP-A 8-12600 and the tetraarylethene derivatives described in JP-A 8-12969.

It is preferred to use the fluorescent material in combination with a host material capable of light emission by itself, that is, to use the fluorescent material as a dopant. In this embodiment, the content of the fluorescent material in the light emitting layer is preferably 0.01 to 20% by volume, especially 0.1 to 15% by volume. In particular, an appropriate content of rubrene is 0.01 to 20% by volume. By using the fluorescent material in combination with the host material, the light emission wavelength of the host material can be altered, allowing light emission to be shifted to a longer wavelength and improving the luminous efficacy and stability of the device.

As the host material, quinolinolato complexes are preferable, with aluminum complexes having 8-quinolinol or a derivative thereof as the ligand being more preferable. These aluminum complexes are disclosed in JP-A 63-264692, 3-255190, 5-70773, 5-258859 and 6-215874.

Illustrative examples include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolatoaluminum, tris(5,7-dibromo-8-hydroxyquinolinolato)aluminum, and poly[zinc(II)-bis(8-hydroxy-5-quinolinyl)methane].

Other useful host materials are the phenylanthracene derivatives described in JP-A 8-12600 and the tetraarylethene derivatives described in JP-A 8-12969.

The light emitting layer may also serve as an electron injecting and transporting layer. In this embodiment, the use of tris(8-quinolinolato)aluminum and analogues is preferred. These fluorescent materials may be evaporated.

If desired, the light emitting layer is a layer of a mixture of at least one hole injecting and transporting compound and at least one electron injecting and transporting compound, which may contain a dopant. In such a mix layer, the content of the dopant is preferably 0.01 to 20% by volume, especially 0.1 to 15% by volume.

In the mix layer, carrier hopping conduction paths are created, allowing carriers to move through a polarly predominant material while injection of carriers of opposite polarity is rather inhibited. The organic compound is less susceptible to damage, resulting in the advantage of an extended device life. By incorporating the dopant in such a mix layer, the light emission wavelength the mix layer itself possesses can be altered, enabling light emission shifted to a longer wavelength and improving the luminous intensity and stability of the device.

The hole injecting and transporting compound and electron injecting and transporting compound used in the mix layer may be selected from compounds for the hole injecting and transporting layer and compounds for the electron injecting and transporting layer to be described later, respectively. Specifically, the compounds for the hole injecting and transporting layer are preferably amine derivatives having strong fluorescence, for example, triphenyldiamine (TPD) derivatives, styrylamine derivatives and amine derivatives having an aromatic fused ring known as the hole transporting material.

The compounds for the electron injecting and transporting layer are preferably quinoline derivatives and metal complexes having 8-quinolinol or a derivative thereof as a ligand, especially tris(8-quinolinolato)aluminum (Alq3). The phenylanthracene derivatives and tetraarylethene derivatives described above are also preferably used.

With respect to the mix ratio, which is determined in consideration of the respective carrier mobility and carrier concentration, it is preferred that the weight ratio of the hole injecting and transporting compound to the electron injecting and transporting compound range from about 1/99 to 99/1, more preferably from about 10/90 to 90/10, especially from about 20/80 to 80/20.

The thickness of the mix layer preferably ranges from the thickness corresponding to a single molecule layer to less than the thickness of an organic compound layer, for example, preferably from 1 to 85 nm, more preferably 5 to 60 nm, most preferably 5 to 50 nm.

Preferably the mix layer is formed by a co-deposition process of evaporating the compounds from distinct sources. If both the compounds have equal or very close vapor pressure or evaporation temperature, they may be pre-mixed in a common evaporation boat, from which they are evaporated together. The mix layer is preferably a uniform mixture of both the compounds although the compounds can be present in island form. The light emitting layer is generally formed to a predetermined thickness by evaporating an organic fluorescent material or coating a dispersion thereof in a resin binder.

In the hole injecting and transporting layer, there may be used various organic compounds as described, for example, in JP-A 63-295695, 2-191694, 3-792, 5-234681, 5-239455, 5-299174, 7-126225, 7-126226, and 8-100172, and EP 0650955A1. Exemplary are tetraarylbenzidine compounds (triaryldiamines or triphenyldiamines: TPD), aromatic tertiary amines, hydrazone derivatives, carbazole derivatives, triazole derivatives, imidazole derivatives, oxadjazole derivatives having an amino group, and polythiophenes. Two or more of these compounds may be used, and on such combined use, they may be formed as separate layers or mixed.

Where the hole injecting and transporting layer is formed separately as a hole injecting layer and a hole transporting layer, two or more compounds are selected in a proper combination from the compounds commonly used in hole injecting and transporting layers. In this regard, it is preferred to laminate layers in such an order that a layer of a compound having a lower ionization potential may be disposed adjacent the hole injecting electrode (ITO). It is also preferred to use a compound having good thin film forming ability at the hole injecting electrode surface. The order of lamination also applies where a plurality of hole injecting and transporting layers are provided. Such an order of lamination is effective for lowering the drive voltage and preventing current leakage and the development and growth of dark spots. Since evaporation is utilized in the manufacture of devices, films as thin as about 1 to 10 nm can be formed uniform and pinhole-free, which restrains any change in color tone of light emission and a drop of efficiency by re-absorption even if a compound having a low ionization potential and absorption in the visible range is used in the hole injecting layer. Like the light emitting layer, the hole injecting and transporting layer may be formed by evaporating the above-mentioned compounds.

In the electron injecting and transporting layer, there may be used quinoline derivatives including organic metal complexes having 8-quinolinol or a derivative thereof as a ligand such as tris(8-quinolinolato)aluminum (Alq3). oxadiazole derivatives, perylene derivatives, pyridine derivatives, pyrimidine derivatives, quinoxaline derivatives, diphenyiquinone derivatives, and nitro-substituted fluorene derivatives. The electron injecting and transporting layer can also serve as the light emitting layer. In this case, use of tris(8-quinolinolato)aluminum etc. is preferred. Like the light emitting layer, the electron injecting and transporting layer may be formed by evaporation or the like.

Where the electron injecting and transporting layer is formed separately as an electron injecting layer and an electron transporting layer, two or more compounds are selected in a proper combination from the compounds commonly used in electron injecting and transporting layers. In this regard, it is preferred to stack layers in such an order that a layer of a compound having a greater electron affinity may be disposed adjacent the electron injecting electrode. The order of stacking also applies where a plurality of electron injecting and transporting layers are provided.

In forming the hole injecting and transporting layer, the light emitting layer, and the electron injecting and transporting layer, vacuum evaporation is preferably used because homogeneous thin films are available. By utilizing vacuum evaporation, there is obtained a homogeneous thin film which is amorphous or has a crystal grain size of less than 0.2 µm. If the grain size is more than 0.2 µm, uneven light emission would take place and the drive voltage of the device must be increased with a substantial drop of charge injection efficiency.

The conditions for vacuum evaporation are not critical although a vacuum of 10⁻⁴ Pa or lower and a deposition rate of about 0.01 to 1 nm/sec are preferred. It is preferred to successively form layers in vacuum because the successive formation in vacuum can avoid adsorption of impurities on the interface between the layers, thus ensuring better performance. Also, the drive voltage of a device can be reduced and the development and growth of dark spots be restrained.

In the embodiment wherein the respective layers are formed by vacuum evaporation, where it is desired for a single layer to contain two or more compounds, preferably boats having the compounds received therein are individually temperature controlled to achieve co-deposition.

The substrate may be provided with a color filter film, a fluorescent material-containing color conversion film or a dielectric reflecting film for controlling the color of light emission.

The color filter film used herein may be a color filter as used in liquid crystal displays and the like. The properties of a color filter may be adjusted in accordance with the light emission of the organic EL device so as to optimize the extraction efficiency and color purity.

It is also preferred to use a color filter capable of cutting external light of short wavelength which is otherwise absorbed by the EL device materials and fluorescent conversion layer, because the light resistance and display contrast of the device are improved.

An optical thin film such as a dielectric multilayer film may be used instead of the color filter.

The organic EL device used herein is generally of the dc or pulse drive type. The applied voltage is generally about 2 to 30 volts.

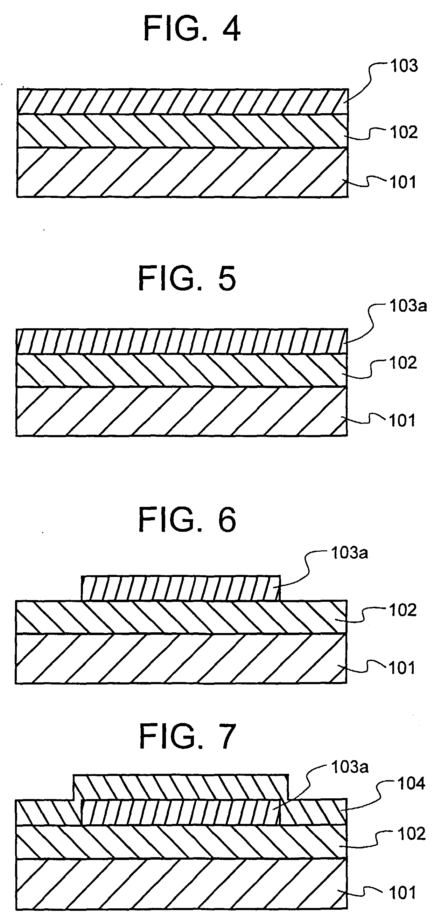

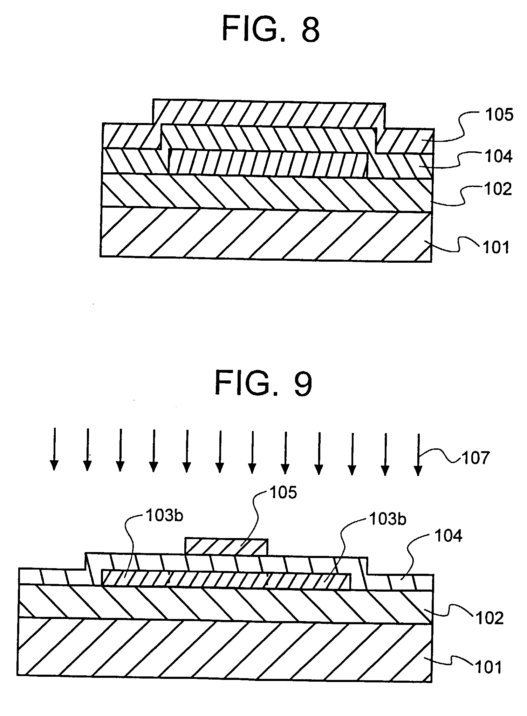

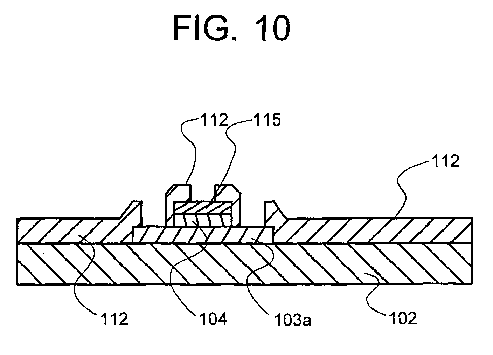

Next, one exemplary thin film transistor (TFT) is described. Referring to FIGS. 4 to 10, there are illustrated successive steps of a process for manufacturing a TFT which constructs the image display apparatus of the invention, and especially a light-emitting current driving TFT for conducting drive current across the organic EL device.
(1) As shown in FIG. 4, on a substrate 101 in the form of a quartz plate, for example, a SiO₂ film 102 is deposited to a thickness of about 100 nm by a sputtering technique.
(2) Then, as also shown in FIG. 4, an amorphous silicon (a-Si) layer 103 of about 100 nm thick is deposited on the SiO₂ film 102 by a LPCVD technique. The film deposition conditions include 100 to 500 SCCM of Si₂H₆ gas, 500 SCCM of He gas, a pressure of 0.1-1 Torr, and a heating temperature of 430-500°C.
(3) The structure is then heat treated, effecting solid phase growth of the a-Si layer 103 into polycrystalline silicon. This solid phase growth includes, for example, a first heat treatment in 1 SLM of N₂ at a temperature of 600°C for 5 to 20 hours, followed by a second heat treatment at a temperature of 850°C for 0.5 to 3 hours. This converts the a-Si layer 103 to an active silicon layer 103a as shown in FIG. 5.
(4) Next, as shown in FIG. 6, the poly-Si layer 103a formed in step (4) is patterned to define an island.
(5) As shown in FIG. 7, a gate oxide film 104 is formed over the patterned poly-Si layer 103a. The conditions under which the gate oxide film 104 is formed include 4 SLM of H₂, 10 SCCM of O₂, a treating temperature of 800°C, and a treating time of 5 hours.
(6) Then, as shown in FIG. 8, a silicon layer 105 of 250 nm thick serving as a gate electrode is formed on the gate oxide film 104 by a vacuum CVD technique. The conditions under which the silicon layer 105 is deposited include 200 SCCM of SiH₄ gas containing 0.1% of PH₃, a treating temperature of 640°C, and a treating time of 0.4 hour.
(7) Then, as shown in FIG. 9, etching is effected in accordance with the predetermined pattern to define a gate electrode 105 and expose the gate oxide film 104.
(8) Further, as shown in FIG. 9, those portions of the poly-Si layer which are to become source and drain regions are doped with a dopant such as phosphorus by an ion doping technique using the gate electrode 105 as a mask, forming source and drain regions 106 and 109 which are self-aligned with the gate electrode 105.
(9) The substrate bearing the above-processed structure is then heat treated in a nitrogen atmosphere at 600°C for 6 hours, then at 850°C for 30 minutes for activating the dopant.
(10) Further as shown in FIG. 10, SiO₂ is deposited to a thickness of 400 nm over the entire substrate using tetraethoxysilane (TEOS) as a starting material, which layer is to become an interlayer insulating film 112. The conditions under which the SiO₂ film is formed include 100 SCCM of TEOS gas and a heating temperature of 700°C. Alternatively, the SiO₂ film is formed by a plasma TEOS technique under conditions: 10 to 50 SCCM of TEOS gas, 500 SCCM of O₂ gas, a power of 50 to 300 W, and a treating temperature of 600°C. The formation of the SiO₂ film is followed by patterning necessary for wiring of electrodes, leaving the patterned interlayer insulating film 112, etc.
(11) The thin film transistor constructed as above is further heat treated in a hydrogen atmosphere at 350°C for one hour for effecting hydrogenation to reduce the defect level density of the semiconductor layer.

With the above-mentioned process, a polycrystalline silicon layer having a grain size of the order of 0.5 to 2 µm can be formed. The TFT using this as the active layer has an N channel mobility of about 100 cm²/V·S and a threshold of about 0.5 V. It is noted that the above-described materials and parameters are given merely for illustrative purposes.

Using the thus formed TFT, a driver circuit in the following Example was constructed.

### EXAMPLE

Examples of the invention are given below by way of illustration and not by way of limitation.

### Example 1

A shift register represented by the circuit diagram of FIG. 1 was formed in accordance with the above-mentioned process.

More particularly, a shift register having 648 stages of constituent units shown by the circuit diagram of FIG. 1 was formed. While clock pulses were supplied, input signals are fed to the shift register to see if the shift register operated normally. It was confirmed that a delay signal was delivered from the output of each stage in synchronization with the clock pulse.

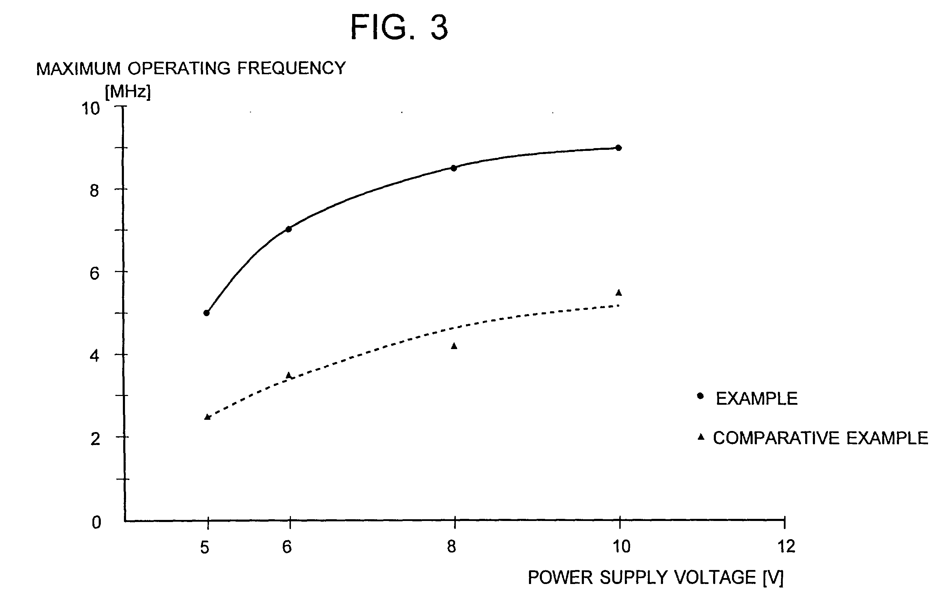

Next, the maximum operating frequency of this shift register relative to the power supply voltage was measured. It is noted that a shift register constructed to the circuit diagram of FIG. 13 was similarly operated as a comparative example. The results are shown in FIG. 3.

As seen from FIG. 3, the operating frequency of the shift register of the invention is about twice greater than that of the comparative shift register at every power supply voltage.

### Example 2

In this example, an image display apparatus was constructed using the shift register of Example 1 and organic EL devices capable of high speed operation as image display devices.

For example, TFTs for driving the organic EL devices serving as pixels were formed as follows. First, an amorphous silicon layer of about 600 Å was deposited on a substrate by a CVD technique. The depositing conditions included 100 SCCM of Si₂H₆ gas, a pressure of 0.3 Torr, and a temperature of 480°C.

The amorphous silicon layer was then converted into an active layer (polycrystalline silicon layer) by solid phase growth. The solid phase growth was effected by heat annealing followed by laser annealing. The heat annealing conditions included 1 SLM of N₂, a temperature of 600°C, and a treating time of 24 hours. The laser annealing used a KrF excimer laser of 254 nm, with an energy density of 200 mJ/cm² and 50 shots.

The poly-Si layer was then patterned, leaving an active silicon layer of 500 Å.

On the active silicon layer, a SiO₂ layer serving as a gate oxide film was deposited to a thickness of about 800 Å by a plasma CVD technique. The deposition conditions included an input power of 50 W, 50 SCCM of TEOS, 500 SCCM of O₂, a pressure of 0.1 to 0.5 Torr, and a temperature of 350°C.

On the SiO₂ layer, a Mo-Si₂ layer serving as a gate electrode was deposited to a thickness of about 1,000 Å by sputtering. The Mo-Si₂ layer and the previously formed SiO₂ layer were then patterned as by dry etching, obtaining a gate electrode and a gate oxide film.

Then, using the gate electrode as a mask, those portions of the active silicon layer that were to become source and drain regions were doped with necessary dopants by an ion doping technique.

The structure was then heated in a nitrogen atmosphere at about 550°C for 10 hours for activating the dopants. The structure was further heated in a hydrogen atmosphere at about 400°C for 30 minutes for effecting hydrogenation to reduce the defect level density of the semiconductor layer.

[0105] Over the entire substrate, a SiO₂ layer serving as an interlayer insulating layer was formed to a thickness of about 8,000 Å. The conditions under which SiO₂ was deposited included 10 SLM of O₂/N₂, 1 SLM of N₂ containing 5% of SiH₄, 500 SCCM of N₂ containing 1% of PH₃, 10 SLM of N₂, a temperature of 410°C, and atmospheric pressure.

The SiO₂ film serving as an interlayer insulating layer was etched to form contact holes. Aluminum was then evaporated to form drain and source wiring electrodes.

The resulting TFT array had an off current of 4x10⁻¹⁰ A and an electric field of up to 0.2 MV/cm between drain and source.

Next, in the regions where organic EL devices were to be formed, indium tin oxide (ITO) serving as a hole injecting electrode was deposited and connected to the wiring electrodes.

In the pixel regions of the TFT thin film pattern fabricated as above according to the invention (and on ITO), organic layers including a hole injecting and transporting layer, a light emitting layer and a high-resistance electron injecting and transporting layer were formed by vacuum evaporation. The materials evaporated herein are shown below. Only exemplary materials are described herein although any desired material which can be deposited by evaporation is applicable as understood from the above-described concept of organic EL device.

After the substrate on which the ITO electrode layer etc. had been formed was cleaned on its surface with UV/O₃, it was secured by a holder in a sputtering chamber, which was evacuated below 1x10⁻⁴ Pa.

In vacuum, N,N,N',N'-tetrakis(m-biphenyl)-1,1'-biphenyl-4,4'-diamine (TPD) was evaporated at a deposition rate of 0.2 nm/sec to a thickness of 200 nm, forming a hole injecting and transporting layer.

With the vacuum kept, TPD, tris(8-quinolinolato)aluminum (Alq3), and rubrene were evaporated at an overall deposition rate of 0.2 nm/sec to a thickness of 100 nm, forming a light emitting layer. The layer contained TPD and Alq3 in a volume ratio of 1:1 which was doped with 10% by volume of rubrene.

The substrate was then transferred to a sputtering chamber. Using a target of Li₂O having 4 mol% of V mixed therewith, a high-resistance inorganic electron injecting and transporting layer was deposited to a thickness of 10 nm. The sputtering conditions included 30 SCCM of Ar, 5 SCCM of O₂, room temperature (25°C), a deposition rate of 1 nm/min, an operating pressure of 0.2 to 2 Pa, and an input power of 500 W. The inorganic electron injecting layer thus deposited had substantially the same composition as the target.

With the vacuum kept, aluminum was evaporated to a thickness of 100 nm, forming a negative electrode. Finally the structure was sealed with glass, completing the organic EL device.

When the organic EL display apparatus thus obtained was driven in air at a constant current density of 10 mA/cm², it operated normally with an initial luminance of 800 cd/m² and a drive voltage of 7.5 V. It was also confirmed that the pixel that was selected in accordance with the operation of the shift register was driven.

There has been described a shift register which eliminates the influence of the operating speed of polycrystalline silicon and enables high-speed operation. Using the shift register, an image display apparatus can be manufactured at a low cost.

Although some preferred embodiments have been described, many modifications and variations may be made thereto in light of the above teachings. It is therefore to be understood that the invention may be practiced otherwise than as specifically described without departing from the scope of the appended claims.

## Claims

1. A shift register comprising switching devices having an active layer formed of polycrystalline silicon, wherein
an electric charge that is charged to the shift register through a power supply line and discharged therefrom is transferred to a next stage through only one switching device.

2. The shift register of claim 1 comprising a pair of switching devices capable of complimentary operation as an operating unit, wherein a signal is transferred to the next stage by the pair of switching devices.

3. The shift register of claim 1 wherein said operating unit is adapted to transfer an input signal to the next stage in synchronization with a clock signal.

4. The shift register of claim 1 having an off current of up to 1x10⁻⁷ A.

5. The shift register of claim 1 wherein an electric field of up to 0.2 MV/cm is applied between controlled electrodes of each switching device.

6. A shift register comprising a first pair of switching devices having an active layer formed of polycrystalline silicon as a first operating unit, said pair of switching devices being capable of complimentary operation and functioning as an inverter, said shift register further comprising a second pair of complimentary, series connected switching devices, wherein
a clock signal is fed to a controlled terminal of one of said first pair of switching devices, an output of the first operating unit is fed to a control terminal of one of said second pair of switching devices while the clock signal is fed to a control terminal of the other of said second pair of switching devices, and an output signal is delivered from an intermediate between said second pair of switching devices.

7. The shift register of claim 6 having an off current of up to 1x10⁻⁷ A.

8. The shift register of claim 6 wherein an electric field of up to 0.2 MV/cm is applied between controlled electrodes of each switching device.

9. An image display apparatus comprising the shift register of any one of claims 1 to 8.

10. The image display apparatus of claim 9 further comprising an organic EL device as a pixel.
